# EUROPÄISCHE PATENTSCHRIFT

(11) **EP 1 295 519 B1**
(45) Veröffentlichungstag und Bekanntmachung des Hinweises auf die Patenterteilung: **13.10.2004**
(21) Anmeldenummer: 01951350.6
(22) Anmeldetag: 30.05.2001
(51) Int. Cl.: H05K 13/08

(54) **HERSTELLUNGSVERFAHREN FÜR EIN ELEKTRONISCHES GERÄT**
METHOD FOR PRODUCING AN ELECTRONIC DEVICE
PROCEDE DE FABRICATION D'UN APPAREIL ELECTRONIQUE

(30) Priorität: 10.06.2000 DE 10028912
(43) Veröffentlichungstag der Anmeldung: 26.03.2003
(73) Patentinhaber: ROBERT BOSCH GMBH, 70442 Stuttgart (DE)
(72) Erfinder: SCHENK, Joachim, 38536 Meinersen-Ohof (DE); GEIL, Andreas, 70197 Stuttgart (DE); SPICHALE, Thomas, 69436 Schoenbrunn (DE); BAIERL, Wolfgang, 73630 Remshalden (DE)
(86) Internationale Anmeldenummer: PCT/DE2001/002038
(87) Internationale Veröffentlichungsnummer: WO 2001/097586

(56) Entgegenhaltungen:
- EP-A- 0 332 727
- DE-A- 19 850 990
- US-A- 5 771 474

## Beschreibung

### STAND DER TECHNIK

Die Erfindung betrifft ein Herstellungsverfahren für ein aus mehreren Komponenten zusammengesetztes elektronisches Gerät, wobei wenigstens eine der Komponenten programmgesteuert ist und ein Prüfprogramm ausgeführt wird.

Ein solches Herstellungsverfahren ist aus US-A-5 771 474 bekannt.

Derartige Geräte kommen in vielen Bereichen der Technik vor, und ihre Verbreitung nimmt zu, da der Fortschritt der Mikroelektronik den Aufbau auch hochspezialisierter Geräte aus modularen Komponenten immer weiter vereinfacht und wirtschaftlich attraktiv macht.

Ein wirtschaftlich wichtiges Beispiel für ein solches Gerät ist zum Beispiel die Gesamtheit der Steuerelektronik und - elektrik eines Kraftfahrzeugs, hier kurz als Steuersystem bezeichnet.

Gegenwärtig ist es üblich, bei der Montage von Kraftfahrzeugen sämtliche zum Steuersystem gehörenden Komponenten der Reihe nach zu montieren und nach Abschluß der Montage, am Bandende, eine Funktionsprüfung durchzuführen. Eine solche Vorgehensweise ist jedoch aus mehreren Gründen unbefriedigend. So können zum einen Fehler, die erst nach Montageende festgestellt werden, häufig nur dadurch behoben werden, daß Montageschritte rückgängig gemacht werden, um eine fehlerhafte Stelle zugänglich zu machen und zu reparieren. Dies ist nicht nur zeitaufwendig, sondern es erfordert mitunter die Zerstörung von Teilen.

Zum anderen resultiert ein weiteres Problem aus der zunehmenden Komplexität der Steuersysteme für Kraftfahrzeuge. Da die einzelnen Komponenten eines solchen Steuersystems in vielfältiger Weise miteinander wechselwirken, läßt sich nämlich häufig aus dem Auftreten eines Fehlers nicht eindeutig auf den Defekt einer bestimmten Komponente schließen. Um die Ursache eines festgestellten Fehlers lokalisieren zu können, ist es daher häufig erforderlich, daß einzelne programmgesteuerte Komponenten eines solchen Systems veranlaßt werden, ein Prüfprogramm auszuführen, das sich von dem Arbeitsprogramm, welches diese Komponenten im Normalbetrieb des Steuersystems ausführen, unterscheidet und das dazu dient, die ordnungsgemäße Funktionsfähigkeit der programmgesteuerten Komponente oder von in ihrer Funktion von dieser letzteren abhängigen Komponenten wie z.B. Sensoren oder Aktoren, nachzuweisen. Falls die mit einem solchen Prüfprogramm geprüfte Komponente sich als funktionsfähig erweist, muß der Vorgang an einer anderen wiederholt werden, bis die defekte gefunden ist. Eine solche Vorgehensweise wird mit in Kfz-Werkstätten verbreiteten sogenannten Diagnose-Testern praktiziert. Für den systematischen Einsatz in der Serienfertigung ist eine solche Vorgehensweise zu zeitaufwendig.

### VORTEILE DER ERFINDUNG

Das erfindungsgemäße Herstellungsverfahren mit den Merkmalen des Hauptanspruchs ermöglicht die wirtschaftliche Herstellung von komplexen elektrischen bzw. elektronischen Geräten, unter Vermeidung von Zeitverlusten durch Versuche zur Fehlerlokalisierung und unter Vermeidung von Demontagemaßnahmen, die andernfalls nötig sein könnten, um den Ort eines Fehlers zugänglich zu machen.

Dabei ist es nicht erforderlich, daß die Durchführung des Prüfprogramms unmittelbar auf den Einbau der zu prüfenden programmgesteuerten Komponente folgt; z.B. ist es denkbar, mehrere solche Komponenten nacheinander einzubauen und diese dann in einem gemeinsamen Arbeitsgang zu überprüfen, wesentlich ist jedoch, daß die Überprüfung vor Abschluß der Montage zu einem Zeitpunkt erfolgt, wo der Zugang zu der eingebauten Komponente, falls er sich zur Behebung eines Fehlers als notwendig erweisen sollte, nicht unnötig erschwert ist.

Das Prüfprogramm wird vor dem Einbau der programmgesteuerten Komponente in einem Programmspeicher dieser Komponente gespeichert. Auf diese Weise erübrigt sich ein zeitaufwendiges Laden eines solchen Prüfprogramms vor dessen Ausführung.

Programmteile, die von dem Prüfprogramm und von einem im Normalbetrieb des Geräts von der programmgesteuerten Komponente auszuführenden Arbeitsprogramm genutzt werden, werden zweckmäßigerweise ebenfalls in dem Programmspeicher vorab gespeichert. Auf diese Weise erübrigt sich ein zweimaliges Laden dieser Programmteile. Die "gemeinsame Nutzung" von Programmteilen durch Arbeitsprogramm und Prüfprogramm ist hier in einem umfassenden Sinne zu verstehen; insbesondere umfaßt sie auch solche Programmteile, die von dem Prüfprogramm lediglich mit dem Ziel aufgerufen werden, zu überprüfen, daß die programmgesteuerte Komponente diese Teile korrekt ausführt.

Nach erfolgreicher Durchführung des Prüfprogramms wird dieses vorzugsweise als ausgeführt gekennzeichnet, im Programmspeicher gelöscht oder überschrieben. Dieser Verfahrensschritt erlaubt zu einem späteren Zeitpunkt die Überprüfung, daß das Prüfprogramm ordnungsgemäß ausgeführt worden ist; dies erlaubt es einem Gerätehersteller insbesondere bei sicherheitsrelevanten Geräten, auch lange Zeit nach der Herstellung noch nachzuweisen, daß er mit Bezug auf ein bestimmtes Gerät einer Qualitätssicherungpflicht genügt hat.

Während die Kennzeichnung des Prüfprogramms einen direkten Nachweis von dessen ordnungsgemäßer Durchführung erlaubt, ist dies beim Löschen oder Überschreiben nicht ohne weiteres der Fall. Daher ist es sehr zweckmäßig, wenn das Prüfprogramm nach Ausführung mit dem Arbeitsprogramm überschrieben wird. In einem solchen Fall ist allein aus der Tatsache, daß das betreffende Gerät einmal korrekt funktioniert hat, der Nachweis möglich, daß ein Arbeitsprogramm vorhanden gewesen sein muß, und aus dem Vorhandensein des Arbeitsprogramms kann geschlossen werden, daß auch die Funktionsprüfung des Geräts vorgenommen worden sein muß.

Um Informationen über eventuelle Fehler der programmgesteuerten Komponente zu erhalten, ist es zweckmäßig, daß eine Diagnoseeinheit an eine Schnittstelle des Geräts angeschlossen wird, über die sie Meldungen über eventuell bei Ausführung des Prüfprogramms festgestellte Fehler von der programmgesteuerten Komponente empfangen kann.

Da die Überprüfung der Komponente in einem unfertigen Zustand des Gerätes vorgenommen wird, in dem dieses möglicherweise noch über keine Energieversorgung für die Komponente verfügt, ist es zweckmäßig, daß die zur Ausführung des Prüfprogramms benötigte Energie der programmgesteuerten Komponente über die Schnittstelle zugeführt wird.

Die gleiche Schnittstelle kann auch dazu dienen, nach erfolgreicher Durchführung des Prüfprogramms das Arbeitsprogramm an die programmgesteuerten Komponente zu übertragen.

Gegenstände der Prüfung durch das Prüfprogramm sind sinnvollerweise z.B. eine Überprüfung der Verbindungen der programmgesteuerten Komponente mit anderen Teilen des Geräts sowie des ordnungsgemäßen Vorhandenseins der vom Arbeitsprogramm und dem Prüfprogramm gemeinsam genutzten Programmteile. Hier sind insbesondere Fehler der Art denkbar, daß bei der Herstellung versäumt wird, einen Programmteil, der ein bestimmtes Leistungsmerkmal des herzustellenden Gerätes implementiert, in den Programmspeicher zu laden bzw. daß ein Programmspeicher eingebaut wird, der diesen Programmteil nicht enthält, oder daß eine veraltete Version eines Programmteils im Programmspeicher vorhanden ist, die den Qualitäts- oder Sicherheitsanforderungen nicht mehr genügt, oder bei der, z.B. in Folge von Änderungen an anderen Komponenten des Geräts, nicht gewährleistet ist, daß sie mit allen anderen Komponenten des Geräts reibungslos zusammenarbeitet.

### ZEICHNUNG

Ausführungsbeispiele der Erfindung sind in der Zeichnung dargestellt und in der nachfolgenden Beschreibung näher erläutert.

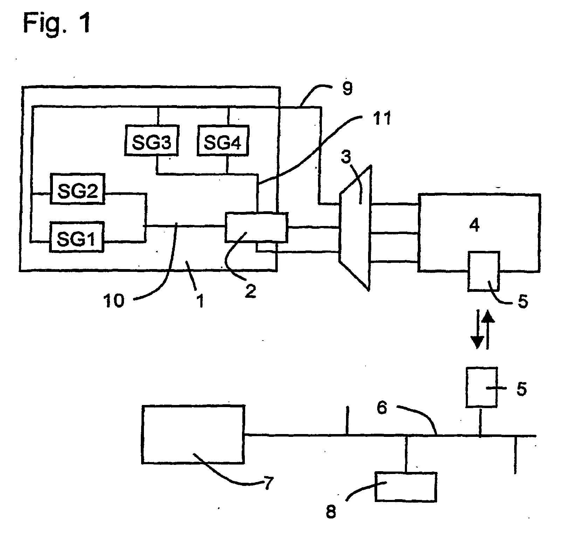

- Figur 1: zeigt eine schematische Übersicht eines Diagnosesystems zur Durchführung des erfindungsgemäßen Verfahrens.

Das Bezugszeichen 1 bezeichnet hier ein in der Herstellung begriffenes elektronisches oder elektrisches Gerät wie etwa das gesamte Steuersystem eines Kraftfahrzeuges, das aus einer Mehrzahl von Komponenten zusammengesetzt wird, von dem in der Figur nur beispielhaft programmgesteuerte Komponenten SG1, SG2, ... SG4 gezeigt sind. Bei diesen programmgesteuerten Komponenten SG1, ... SG4 kann es sich z.B. um eine Steuereinheit für Kraftstoffzufuhr und Zündung der Brennkraftmaschine des Fahrzeugs, eine Airbag-Zündsteuereinheit oder dergleichen handeln. Jede programmgesteuerte Komponente verfügt über einen Programmspeicher. Dieser kann mit ihr zusammen zu einer Einheit verbunden und gemeinsam mit ihr in das Gerät 1 eingebaut sein; denkbar ist aber auch der Einbau einer Komponente und eines zugeordneten Programmspeichers in das Gerät 1 in getrennten Schritten.

Als Beispiel wird angenommen, daß SG4 die zuletzt eingebaute Komponente ist. Der Programmspeicher (nicht dargestellt) dieser Komponente enthält eine Reihe von Programmteilen, die von dem später zu ladenden Arbeitsprogramm der Komponente SG4 benötigt werden, sowie ein Prüfprogramm, durch dessen Ausführung die Komponente SG4 in der Lage ist, zu prüfen, welche vom Arbeitsprogramm benötigten Programmteile bereits im Programmspeicher enthalten sind, ob die jeweils aktuelle Fassung dieser Programmteile vorhanden ist und ob alle Kontakte der Komponente SG4 zu ihrer Umgebung korrekt sind, das heißt, ob alle Steckverbinder, über die die Komponente SG4 mit ihrer Umgebung Signale austauscht, korrekt angeschlossen sind.

Um die Komponente SG4 zu prüfen, wird ein Diagnose-Tester 4 über eine Schnittstelle 3 in Form eines speziellen Steckverbinders an das Gerät 1 angeschlossen. Über die Schnittstelle 3 und eine Versorgungsleitung 9 versorgt der Diagnose-Tester 4 die Komponente SG4 sowie die anderen bereits eingebauten Komponenten SG1 bis SG3 mit Energie, so daß die Komponente SG4 beginnt, das Prüfprogramm abzuarbeiten. Da auch die Komponenten SG1 bis SG3 mit Energie versorgt werden, kann das Prüfprogramm der Komponente SG4 über ein internes Bussystem des Gerätes 1 wie etwa einen CAN-Bus 11 und eine K-Leitung 10 die bereits eingebauten Komponenten ansprechen und überprüfen, ob es mit diesen korrekt verbunden ist und von ihnen eine erwartete Antwort auf eine Anfrage empfängt. Im Laufe der Abarbeitung des Prüfprogramms liefert die programmgesteuerte Komponente SG4 Meldungen über die Ergebnisse der Prüfung über den CAN-Bus 11, ein Gateway 2 und die Schnittstelle 3 an den Diagnose-Tester 4. Die Ergebnismeldungen können sich auf Fehlermeldungen beschränken, zweckmäßig ist es jedoch, auch eine Meldung über den erfolgreichen Abschluß eines Prüfschrittes an den Diagnose-Tester 4 zu liefern.

Bei dem hier gezeigten Beispiel überträgt der Diagnose-Tester 4 die erhaltenen Prüfergebnisse über eine hier als Infrastruktur-Schnittstelle 5 bezeichnete Schnittstelle weiter an eine Prüf- bzw. Qualitätssicherungs-Infrastruktur des Herstellers des Geräts 1. Die Infrastruktur-Schnittstelle ist vorzugsweise eine drahtlose Schnittstelle, sie überträgt Daten z.B. in Form von Funk- oder Infrarot-Signalen. Eine solche drahtlose Übertragung der Prüfergebnisse erlaubt es einer Bedienungsperson, den Diagnose-Tester 4 an einer beliebigen Stelle zu plazieren, wo er das zu überprüfende Gerät leicht erreichen kann; eine solche schnurlose Verbindung ermöglicht es aber auch, einen Diagnose-Tester 4 während der Herstellung des zu testenden Geräts an diesem zu belassen, so daß es mit dem Gerät auf einer Fertigungsstraße mitwandert und den Diagnose-Tester jeweils an einzelnen Orten der Fertigungsstraße im Anschluß an den Einbau einer zu prüfenden Komponente über die Infrastruktur-Schnittstelle 5 anzusprechen, um die Ausführung des Prüfprogramms dieser Komponente zu veranlassen.

Die Prüfinfrastruktur umfaßt ihrerseits eine zu der Infrastruktur-Schnittstelle 5 des Diagnose-Testers 4 komplementäre, insbesondere baugleiche Schnittstelle 5, angeschlossen an ein Bussystem 6, an das ferner ein Computer, hier als MBD-Server 7 (für montagebegleitende Diagnose) bezeichnet, und eine Anzeigeeinheit 8 angeschlossen sind. Mit Hilfe des MBD-Servers 7 können sämtliche bei der montagebegleitenden Diagnose erhaltenen Prüfergebnisse für ein gegebenes Gerät 1 auf einfache und wirtschaftliche Weise aufgezeichnet und archiviert werden. Auf diese Weise hat der Hersteller des Gerätes 1 in dem Fall, daß das Gerät in einen Unfall verwickelt worden ist oder zu einer Störung geführt hat, jederzeit die Möglichkeit, auf die Prüfdaten des entsprechenden Gerätes zuzugreifen und so nachzuweisen, daß das Gerät in gründlich getestetem und einwandfreiem Zustand sein Haus verlassen hat. Darüber hinaus ermöglicht das Sammeln von Prüfdaten für eine Vielzahl von Geräten in verschiedenen Stufen ihrer Herstellung, Herstellungsschritte zu erkennen, die möglicherweise eine Gefährdung bereits installierter Komponenten beinhalten oder auf andere Weise zu Störungen führen können.

Falls die Abarbeitung des Prüfprogramms dazu führt, daß ein Fehler erkannt wird, so kann dieser auf der Anzeigeeinheit 8 angezeigt werden, um eine Bedienungsperson zu veranlassen, das betreffende Gerät 1 auszusondern, damit es, gegebenenfalls anhand von ebenfalls auf der Anzeigeeinheit 8 angezeigten Hinweisen, repariert werden kann. Das reparierte Gerät wird der Funktionsprüfung von neuem unterzogen, und erst wenn es diese besteht, wird die Herstellung durch Einbau weiterer Komponenten fortgesetzt.

Wenn der Aspekt des Sammelns von Diagnose-Daten von nachrangiger Bedeutung ist, kann das erfindungsgemäße Verfahren auch ohne die Elemente 5 bis 8 durchgeführt werden. In diesem (in der Figur nicht dargestellten) Fall verfügt zweckmäßigerweise der Diagnose-Tester 4 über eine eigene Anzeigeeinheit 8, um eine Störung des in der Prüfung befindlichen Geräts und gegebenenfalls Hinweise zur Beseitigung der Störung anzuzeigen.

Nachdem das Prüfprogramm erfolgreich, das heißt ohne Feststellung von Fehlern, ausgeführt worden ist, wird es für die Zwecke der Herstellung des Gerätes nicht mehr benötigt. Der Programmspeicher, in dem es gespeichert ist, kann daher einer anderen Verwendung zugeführt werden, zweckmäßigerweise wird das Prüfprogramm mit dem Arbeitsprogramm überschrieben, das die Komponente während des Normalbetriebs, für den das Gerät 1 vorgesehen ist, ausführt.

Wenn das Gerät 1 lediglich eine programmgesteuerte Komponente aufweist, kann unmittelbar nach erfolgreicher Durchführung des Prüfprogramms das Arbeitsprogramm in den Arbeitsspeicher übertragen werden. Zur Übertragung der Programmdaten ist es möglich, die Schnittstelle 3 und den Diagnose-Tester 4 einzusetzen. Wenn das Gerät 1 mehrere programmgesteuerte Komponenten enthält, kann es für die Herstellung ökonomischer sein, diese Komponenten jeweils nacheinander einzubauen und zu überprüfen, und nach erfolgreicher Beendigung aller Prüfungen die Arbeitsprogramme aller programmgesteuerten Komponenten des Geräts zu laden.

## Patentansprüche

1. Herstellungsverfahren für ein aus mehreren Komponenten (SG1, SG2, SG3, SG4) zusammengesetztes elektronisches Gerät, wobei wenigstens eine der Komponenten (SG4) programmgesteuert ist, bei dem nach dem Einbau der programmgesteuerten Komponente (SG4) und vor dem Abschluss der Herstellung des Geräts (1) die programmgesteuerte Komponente (SG4) veranlasst wird, ein Prüfprogramm auszuführen, wobei das Prüfprogramm vor dem Einbau in einem Programmspeicher der programmgesteuerten Komponente (SG4) gespeichert wurde, und die Herstellung des elektronischen Geräts (1) nur fortgesetzt wird, wenn bei der Durchführung des Prüfprogramms keine Fehler festgestellt werden.

2. Verfahren nach Anspruch 1, **dadurch gekennzeichnet, dass** Programmteile, die von dem Prüfprogramm und von einem im Normalbetrieb des Geräts (1) von der Komponente (SG4) auszuführenden Arbeitsprogramm genutzt werden, vor dem Einbau der programmgesteuerten Komponente (SG4) in einem Programmspeicher dieser Komponente (SG4) gespeichert werden.

3. Herstellungsverfahren nach Anspruch 1 oder 2, **dadurch gekennzeichnet, dass** nach der Durchführung des Prüfprogramms dieses gekennzeichnet oder im Programmspeicher gelöscht oder überschrieben wird.

4. Herstellungsverfahren nach Anspruch 2, **dadurch gekennzeichnet, dass** das Prüfprogramm mit dem Arbeitsprogramm überschrieben wird.

5. Herstellungsverfahren nach einem der vorhergehenden Ansprüche, **dadurch gekennzeichnet, dass** eine Diagnoseeinheit (4) an eine Schnittstelle (3) des Geräts (1) angeschlossen wird, um Meldungen über eventuell bei Ausführung des Prüfprogramms festgestellte Fehler von der programmgesteuerten Komponente (SG4) zu empfangen.

6. Herstellungsverfahren nach Anspruch 5, **dadurch gekennzeichnet, dass** die programmgesteuerte Komponente (SG4) über die Schnittstelle (3) mit Energie zur Ausführung des Prüfprogramms versorgt wird.

7. Herstellungsverfahren nach Anspruch 5 oder 6, soweit er auf Anspruch 4 rückbezogen ist, **dadurch gekennzeichnet, dass** das Arbeitsprogramm über die Schnittstelle (3) an die programmgesteuerte Komponente übertragen wird.

8. Herstellungsverfahren nach einem der vorhergehenden Ansprüche, **dadurch gekennzeichnet, dass** wenn mehrere Komponenten (SG1, SG2, SG3, SG4) des Geräts (1) programmgesteuert sind, deren Arbeitsprogramme in einem Schritt nach Einbau dieser mehreren programmgesteuerten Komponenten (SG1, SG2, SG3, SG4) übertragen werden.

9. Herstellungsverfahren nach einem der vorhergehenden Ansprüche, **dadurch gekennzeichnet, dass** die Durchführung des Prüfprogramms eine Überprüfung der Verbindungen der programmgesteuerten Komponente (SG4) mit anderen Teilen (SG1, SG2, SG3) des Geräts (1) umfasst.

10. Herstellungsverfahren nach Anspruch 2, **dadurch gekennzeichnet, dass** die Durchführung des Prüfprogramms eine Überprüfung des ordnungsgemäßen Vorhandenseins der vom Arbeitsprogramm und dem Prüfprogramm gemeinsam genutzten Programmteile umfasst.

## Claims

1. Method for manufacturing an electronic device which is composed of a plurality of components (SG1, SG2, SG3, SG4), at least one of the components (SG4) being programme-controlled, in which, after the installation of the programme-controlled component (SG4) and before the manufacture of the device (1) is concluded, the programme-controlled component (SG4) is made to execute a check programme, the check programme having been stored in a programme memory of the programme-controlled component (SG4) before the installation, and the manufacture of the electronic device (1) being continued only if no defaults are detected while the check programme is being executed.

2. Method according to Claim 1, **characterized in that** programme parts which are used by the check programme and by a working programme shich is to be executed by the component (SG4) during normal operation of the device (1) are stored in a programme memory of the programme-controlled component (SG4) before said component (SG4) is installed.

3. Method for manufacturing according to Claim 1 or 2, **characterized in that** after the check programme has been executed, it is characterized or deleted in the programme memory or overwritten.

4. Method for manufacturing according to Claim 2, **characterized in that** the check programme is overwritten with the working programme.

5. Method for manufacturing according to one of the preceding claims, **characterized in that** a diagnostic unit (4) is connected to an interface (3) of the device (1) in order to receive messages from the programme-controlled component (SG4) about faults which are possibly being detected while the check programme is being executed.

6. Method for manufacturing according to Claim 5, **characterized in that** the programme-controlled component (SG4) is supplied via the interface (3) with power for executing the check programme.

7. Method for manufacturing according to Claim 5 or 6 in so far as it is referred back to Claim 4, **characterized in that** the working programme is transferred to the programme-controlled component via the interface (3).

8. Method for manufacturing according to one of the preceding claims, **characterized in that** if a plurality of components (SG1, SG2, SG3, SG4) of the device (1) are programme-controlled, their working programmes are transferred in a step after installation of this plurality of programm-controlled components (SG1, SG2, SG3, SG4).

9. Method for manufacturing according to one of the preceding claims, **characterized in that** the execution of the check programme comprises checking the connections of the programme-controlled component (SG4) to other parts (SG1, SG2, SG3) of the device (1).

10. Method for manufacturing according to Claim 2, **characterized in that** the execution of the check programme comprises checking the satisfactory presence of the programme parts which are used jointly by the working programme and the check programme.

## Revendications

1. Procédé de fabrication d'un appareil électronique formé de plusieurs composants (SG1, SG2, SG3, SG4), au moins l'un des composants (SG4) étant commandé par programme (SG4) et avant la fin de la fabrication de l'appareil (1), on demande au composant commandé par programme (SG4) d'exécuter un programme de vérification, ce programme de vérification étant enregistré dans une mémoire de programme du composant commandé par programme (SG4) avant son montage et on ne poursuit la fabrication de l'appareil électronique (1) que si l'exécution du programme de vérification ne décèle aucun défaut.

2. Procédé de fabrication selon la revendication 1,
**caractérisé en ce que**
les parties de programme utilisées par le programme de vérification et par un programme de travail exécuté en fonctionnement normal de l'appareil (1) par le composant (SG4), sont enregistrées avant l'installation du composant commandé par programme (SG4) dans une mémoire de programme de ce composant (SG4).

3. Procédé de fabrication selon l'une quelconque des revendications 1 ou 2,
**caractérisé en ce qu'**
après l'exécution du programme de vérification, celui-ci est référencé ou est effacé dans la mémoire de programme ou est transcrit.

4. Procédé de fabrication selon la revendication 2,
**caractérisé en ce qu'**
on transcrit le programme de travail sur le programme de vérification.

5. Procédé de fabrication selon l'une quelconque des revendications précédentes,
**caractérisé en ce qu'**
on raccorde une unité de diagnostic (4) à une interface (3) de l'appareil (1) pour recevoir des messages concernant d'éventuels défauts constatés dans l'exécution du programme de vérification par le composant commandé par programme (SG4).

6. Procédé de fabrication selon la revendication 5, **caractérisé en ce que**
le composant commandé par programme (SG4) est alimenté en énergie par l'interface (3) pour exécuter le programme de vérification.

7. Procédé de fabrication selon l'une quelconque des revendications 5 ou 6, dépendant de la revendication 4,
**caractérisé en ce que**
le programme de travail est transmis par l'intermédiaire de l'interface (3) au composant commandé par programme.

8. Procédé de fabrication selon l'une quelconque des revendications précédentes,
**caractérisé en ce que**
si plusieurs composants (SG1, SG2, SG3, SG4) de l'appareil (1) sont commandés par programme, on transmet leur programme de travail dans une étape après le montage de ces différents composants commandés par programme (SG1, SG2, SG3, SG4).

9. Procédé de fabrication selon l'une quelconque des revendications précédentes,
**caractérisé en ce que**
l'exécution du programme de vérification comprend la vérification des liaisons entre le composant commandé par programme (SG4) et d'autres composants (SG1, SG2, SG3) de l'appareil (1).

10. Procédé de fabrication selon la revendication 2,
**caractérisé en ce que**
pour l'exécution du programme de vérification on vérifie que les parties de programme commun servant à la fois au programme de travail et au programme de vérification sont effectivement présentes.
